(19) Europäisches Patentamt
European Patent Office
Office européen des brevets

(11) Publication number: **0 074 860**
**A2**

# (12) EUROPEAN PATENT APPLICATION

(21) Application number: 82304879.8

(22) Date of filing: 16.09.82

(51) Int. Cl.$^{3}$: H 03 K 13/05

(30) Priority: 16.09.81 US 302841

(43) Date of publication of application: 23.03.83 Bulletin 83/12

(84) Designated Contracting States: CH DE FR GB IT LI SE

(71) Applicant: BROOKTREE CORPORATION
Route 1 box N3
Del Mar California 92014(US)

(72) Inventor: Katzenstein, Henry S.
739 Brooktree Road
Pacific Palisades California 90272(US)

(72) Inventor: Sullivan, Herbert W.
205 West End Avenue Apt. 18C
New York New York 10023(US)

(74) Representative: Pears, David Ashley et al,
REDDIE & GROSE 16 Theobalds Road
London WC1X 8PL(GB)

## (54) Digital-to-analog converter.

(57) A plurality of transistor switches (62 - 74) are connected in parallel between a voltage source (76) and an output line (78). There are more switches than input lines (12, 16 and 18) corresponding to three input bits with values 1, 2 and 4 respectively. A logical network (22) controls the switches so that every change of input bits representing an increase in the digital value exclusively adds a conductive transistor switch, whereby there are no discontinuities in the output analog current. The logical network (22) comprises groups of gates (32, 34, 36; 42 - 54) corresponding to each bit other than the least significant and each group forms AND and OR combinations from its own bit and the outputs of the preceding group. To enable modular expansion an additional least significant bit line (14) and gates (24, 30, 40) render an additional transistor switch (60) conductive when all bits have 1 value. The transistor switches and gates can all be combined in an integrated circuit chip, the switches corresponding to each bit being preferably distributed over the chip. Further distributed transistor switches pass a current which is compared with a reference to provide an error signal for controlling the voltage source (76).

EP 0 074 860 A2

Croydon Printing Company Ltd

VOLTAGE SOURCE
Fig.1

0074860

DIGITAL-TO-ANALOG CONVERTER

This invention relates to apparatus for converting data between a digital form and an analog form. More particularly, the invention relates to apparatus which provides such conversion in a simple and reliable manner with minimal errors and with high power and at high frequencies. The invention is especially advantageous because it provides such conversion on a monotonic basis and without any discontinuities in the analog value such as ordinarily occur when the digital signals undergo changes in values such as from a binary value of "511" to a binary value of "512" or from a binary value of "1023" to a binary value of "1024".

Various types of equipment recieve information in analog form. Such equipment includes process control equipment, measuring instruments, communication equipment and a wide variety of other types of equipment. Digital computers and data processing systems receive input parameters in analog form and convert this analog information to digital form for processing in the computer or the data processing equipment. After the analog information has been converted to digital information and has been processed, the output information from the digital computer or the data processing equipment is often converted to analog form. By converting the output information to analog form, the user can assimilate the information in ways which would be difficult or impossible if the information remained in digital form.

A good example of the conversions discussed in the previous paragraph is in the recording and reproduction of music. The music is produced in analog form. It is converted to digital form by recently developed data processing

BAD ORIGINAL

techniques and is recorded on a medium such as a tape or a disc. When the music is to be reproduced, it is converted again to analog form because this is the form which is necessary to operate sound transducers to give meaning to the listener when he hears the music.

As digital computers and data processing equipment have become widespread throughout industry and the office and have even become common in the home, the need for inexpensive, simple and reliable apparatus for converting information between analog and digital forms has become of increasing concern. A considerable effort has been devoted over a period of several decades to provide converting apparatus which is accurate, stable, simple, inexpensive and reliable. In spite of such efforts, the converting apparatus now in use does not meet any of such criteria.

The converting apparatus now in use also has other problems of long standing. For example, the converting apparatus now in use may not be monotonic unless it is quite expensive and complex. By "monotonic" is meant that digital information of progressively increasing value is converted to analog information of progressively increasing value without any decrease in the analog value as the digital value progressively increases. The converting apparatus now in use also has relatively high differential and integral non-linearities unless the apparatus is quite expensive and complex. Integral non-linearities result from errors accumulated in a conversion between analog and digital values over a wide range of such values. Differential non-linearities result from errors produced in a conversion between analog

BAD ORIGINAL

and digital values over a relatively narrow range of such values.

The converting apparatus now in use also has a problem of major proportions. This results when particular digital values are increased incrementally by a single digit. For example, problems in the converters now in use result when a binary representation of "511" is converted to a binary representation of "512". This results from the fact that the binary representation of 511 is 0111111111 and the binary representation of 512 is by 1000000000 where the least significant digit is at the right. As will be seen, the value of each binary digit changes when the decimal value changes from "511" to "512". As a result, discontinuities may occur which prevent the converter from being truly monotonic. This problem even exists in converters which are made quite complex in an attempt to overcome the problem.

In our copending European application of even date No. (Reddie & Grose file 25245) there is described a digital-to-analog converter which significantly decreases the seriousness of at least some of the problems discussed above. Such apparatus is simple, inexpensive and reliable. It can operate with a high precision at high current levels. As a result, the converting apparatus is capable of being used in areas not available for the converters of the prior

BAD ORIGINAL

art. For example, such apparatus is able to convert aural information in analog form into information in digital form and to convert the digital information back to the aural information in analog form by serving both as a converter and a current amplifier.

The apparatus disclosed and claimed in the aforesaid application also has other advantages of some importance. For example, it is capable of providing analog values of progressively increasing value with progressive increases in the digital value, particularly when elements of high precision are used and there are a considerable number of elements in the converter. It is also capable of providing low differential and integral non-linearities, particularly when elements of high precision are used and there are a considerable number of elements in the converter. It is also free of the effects of aging and changes in temperature. It also provides accurate and reliable conversions between analog and digital values at high frequencies with minimal error.

The digital-to-analog converter according to the present invention is defined in claim 1 below.

This invention provides an improvement of the apparatus disclosed and claimed in the aforesaid application.

As a result of this improvement, the converter is truly monotonic. This results in part because the converter of this invention is able to provide a conversion between such binary values as "511" and "512" or between "1023" and "1024" without the production of any discontinuities such as occur in the converters of the prior art.

BAD ORIGINAL

In one embodiment of the invention, a plurality of input lines are provided for receiving digital signals cumulatively representing a particular value and individually having a weighted value of a particular significance. This embodiment also includes a plurality of switches having open and closed states and operative in the closed state to provide a current of a particular value.

A plurality of networks are arranged electrically in a matrix relationship for the digits of progressively increased significance. The networks are connected to one another and to the switches to provide for a flow of current through a number of the switches dependent upon the digital value represented by the digital signals.

Each logical network receives the digital signals of a particular weighted significance and is operatively coupled to the switches and to the logical networks of a significance lower than the particular digital significance to provide for a closure of a number of switches corresponding to the particular weighted significance. Each logical network prepares logical networks in the plurality to close dependent upon the characteristics of the signal of next higher digital significance and the number of switches previously closed. The logical networks maintain the same switches closed with progressive increases in the digital values represented by the digital signals and provide for the closure of additional switches with progressive increases in the digital value. In this way, the converter is monotonic and provides minimal amounts of differential and linear non-linearities. The linear non-linearities are particularly

minimized when switches of high precision are used and there are a considerable number of switches in the converter.

The currents through the closed switches flow to an output line so that the current in the output line represents the analog value. The lines for the digital signals, the switches, the logical networks and the output line may be disposed on an integrated circuit chip by large scale integration (LSI) or a very large scale integration (VLSI) techniques. If desired, a plurality of modules may be disposed on a single integrated circuit chip, each module being formed in the manner described above. The modules may be electrically combined to increase the number of digits in the digital representation.

In the drawings:

Figure 1 is a schematic electrical diagram of a converter constituting one embodiment of the invention for converting between digital and analog signals;

Figure 2 is a schematic diagram of an integrated circuit chip on which the converter shown in Figure 1 may be disposed;

Figure 3 is a schematic diagram of an integrated circuit chip on which a plurality of converters such as shown in Figure 1 may be disposed in modular form;

Figure 4 is a schematic diagram showing the spaced disposition on an integrated circuit chip of different transistors shown in Figure 1;

BAD ORIGINAL

Figure 5 is a block diagram of apparatus included in the converter of Figure 1 to regulate the output from the converter;

Figure 6 is a block diagram showing an analog-to-digital converter which incorporates the apparatus of Figure 1;

Figure 7 is a chart showing the operation of the converter in Figure 1 in converting between analog and digital values; and

Figure 8 is a schematic diagram illustrating how a pair of the converters shown in Figure 1 and 3 can be combined electrically to provide a single converter which is able to provide a conversion involving an increased number of digits.

In one embodiment of the invention, a digital-to-analog converter generally indicated at 10 is provided. The converter 10 receives digital signals on a plurality of input lines 12, 14, 16 and 18. The signals on the lines preferably represent information in binary form. For example, the signals on the lines 12 and 14 may represent a binary value of "1" and the signals on the lines 16 and 18 respectively represent information of progressive binary significance, namely "2" and "$2^2$". Illustratively, a binary "1" may be represented by a signal of high amplitude and a binary "0" may be represented by a signal of low amplitude. Although only three digits are shown, (with duplication of the least significant bit for reasons explained below), it will be appreciated that any particular number of digits may be used. Furthermore, although the information is preferably in binary form, other digital codes may be used.

BAD ORIGINAL

Logical networks generally indicated at 22 are responsive to the signals on the lines 12, 14, 16 and 18 to provide for a conversion of the binary information on the lines into an analog form. Such logical networks are represented by first and second gates. For example, the first gates may be "OR" gates and the second gates may be "AND" gates. The number of gates associated with each of the binary lines 12, 14, 16, 18 and 20 is dependent upon the weighted significance of the binary information represented by the signals on the individual lines.

When "OR" gates and "AND" gates are used, an "OR" gate 26 and an "AND" gate 24 are responsive to the signals on the lines 12 and 14. First input terminals of the "OR" gate 26 and the "AND" gate 24 are connected to the line 12. Second input terminals of the "OR" gate 26 and the "AND" gate 24 are connected to the line 14.

An "AND" network 30 and an "OR" network 32 have first input terminals connected to the output terminal of the "AND" network 24 and have second input terminals connected to the line 16. Similarly, first input terminals of an "AND" network 34 and an "OR" network 36 are connected to the output terminal of the "OR" network 26 and second input terminals of the "AND" network 34 and the "OR" network 26 are connected to the line 16.

An "AND" network 40 and an "OR" network 42, an "AND" network 44 and an "OR" network 46, an "AND" network 48 and an "OR" network 50 and an "AND" network 52 and an "OR" network 54 are respectively associated with the gates 30, 32, 34 and 36 to receive the signals from the output terminals of the gates. Second input terminals of the gates 40, 42, 44, 46, 48, 50, 52 and 54 are connected to the input line 18.

Switches 60, 62, 64, 66, 68, 70, 72 and 74 respectively receive the outputs from the gates 40, 42, 44, 46, 48, 50, 52 and 54. The switches 60 to 74 (even numbers) preferably have substantially identical characteristics. Each of the switches may have open (open-circuit) or closed states. The switches may normally be open and may be triggered to the closed states upon the introduction to the switches of a signal providing for an activation of the associated gate.

The switches may be considered as current-limiting devices having two states of operation. In one state of each switch, no current flows through the switch. In the other state of each switch, a limited current flows through the switch because of the characteristics of the switch.

The switches 60 to 74 (even numbers) may be any suitable type of transistor. For example, they may be MOS field effect transistors of either the p type or n type or thin film transistors or NPN or PNP current mirror bi-polar transistors or channel junction field effect transistors of either the n or p type or switches combined with metallic film resistors in either series or parallel networks.

When the switches 60 to 74 (even numbers) constitute transistors, the activating signals on the outputs of the associates gates 40 to 54 (even numbers) are preferably introduced to the gates or bases of the transistors 60 to 74 (even numbers). The drains or collectors of the transistors 60 to 74 (even numbers) are connected to a voltage source 76. The sources or emitters of the transistors 60 to 74 (even numbers) are connected to an output line 78.

If desired, resistors may be connected between the collectors of the transistors 60 through 74 (even numbers) and the voltage source 76. All of the resistors may have substantially equal values. The resistors may be formed on integrated circuit chips by well known techniques such as impurities in the silicon on the chips or variations in the thickness of the silicon on the chips.

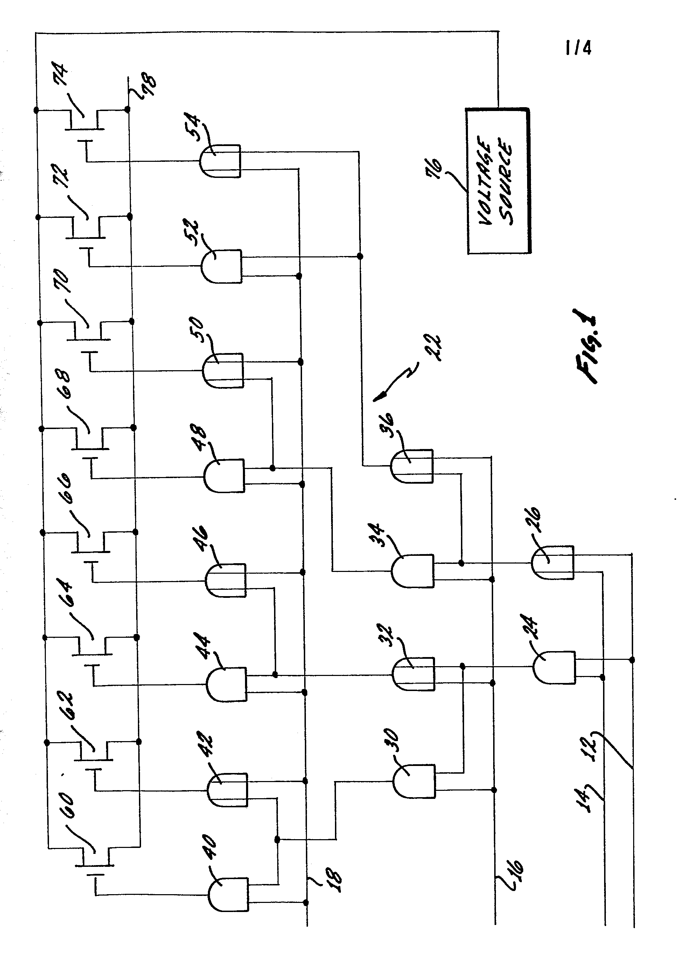

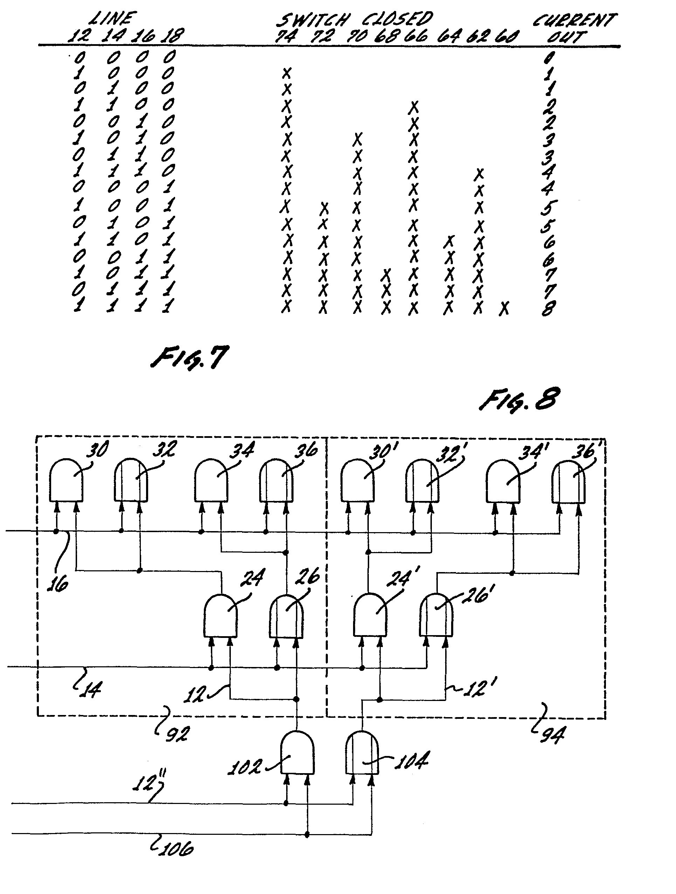

Each of the lines 12 and 14 may provide signals representing a binary value of $2^0$. The signals on the line 16 may represent a binary value of $2^1$ and the signals on the line 18 may represent a value of $2^2$. Accordingly, the matrix arrangement shown in Figure 1 may convert to an analog value any digital representation between the decimal values "0" and "8". This may be seen from the chart in Figure 7. In this chart, binary values of "1" and "0" are produced on the lines 12, 14, 16 and 18 in accordance with the amplitude of the signals on these lines. The chart shown in Figure 7 also indicates a flow of current through each of the transistors 60, 62, 64, 66, 68, 70, 72 and 74 by an "X". The output current on the line 78 is indicated in the last column, which is designated as "Current Out". As will be seen, this current has a decimal magnitude between "0" and "8" corresponding to the analog value to be represented.

The operation of the circuit shown in Figure 1 may be seen from several examples. For example, when signals are provided on the lines 12, 14 and 16 to represent a decimal value of "4", the gates 24 and 26 become activated. The activation of the gate 24 causes the gates 32 and 46 to become activated and the transistor 66 to become conductive. Similarly, the activation of the gate 26 causes the gates 36 and 54 to become activated and the transistor 74 to become conductive. At the same time, the production on the line 16 of a signal representing a binary value of "1" causes the gates 30 and 34 to become activated since signals representing binary values of "1" are simultaneously introduced to the gate 30 from the gate 24 and the line 16 and to the gate 34 from the gate 26 and the line 16. The activation of the gates 30 and 34 in turn causes the gates 42 and 50 to become activated and the transistors 62 and 70 to become conductive. Since four (4) transistors become conductive, an output current having a magnitude of "4" is produced on the output line 78.

As another example, signals representing binary values of "1" may be simultaneously produced on the lines 14 and 18 to represent a decimal value of "5". The introduction to the line 14 of a signal representing a binary value of "1" causes the gates 26, 36 and 54 to become activated and the transistor 74 to become conductive. When a signal representinq a binary value of "1" is simultaneously introduced to the line 18, the gates 42, 46, 50 and 54 become activated and the transistors 62, 66 and 70 become conductive. At the same time, the gate 52 becomes activated because of the simultaneous introduction of signals from the line 18 and the gate 36. This causes the transistor 72 to become conductive. As a result, a current having a magnitude of "5" is produced on the output line 78.

In like manner, paths can be traced through the matrix arrangement for any pattern of signals on the lines 12, 14, 16 and 18. As will be seen for Figure 7, the transistors 60, 62, 64, 66, 68, 70, 72 and 74 become conductive in a pattern where the transistors previously conductive remain conductive and additional transistors become conductive as the decimal value progressively increase from "0" to "8". This may be seen from the pattern of the letter "X" in the chart shown in Figure 7.

There is much redundancy in the chart of Figure 7 and apart from one special case, the combinations using line 14 may be disregarded and, for simple 3-bit conversion, the line 14 and gates 24, 26, 30 and 40 may be omitted from Figure 1, with the line 12 going directly to the gates 34 and 36. The said special case is the last entry in the chart of Figure 1 where it is desired to achieve an output with the value 8, for reasons explained below. The line 12 could still go direct to the gates 34 and 36 (gate 26 omitted) but the AND gates 24, 30, 40 are now needed.

By providing an arrangement in which previously conductive transistors remain conductive and additional transistors become conductive as the digital value progressively increases, the monotonic operation of the converter shown in Figure 1 is assured. Furthermore, when the transistors 60 to 74 (even numbers) are made with precision and when a considerable number of transistors are responsive to the operation of the matrix arrangement shown in Figure 1, the converter operates to provide minimal differential and integral nonlinearities.

Since the transistors previously in the conductive state continue to remain conductive and additional transistors become conductive as the digital value progressively increases, no discontinuities are produced as the number being converted changes from a decimal value such as "511" to a decimal value such as "512" or from a decimal value such as "1023" to a decimal value such as "10248". This further assures that the converter of Figure 1 is nonotonic.

It will be appreciated that the circuitry shown in Figure 1 is schematic only. For example, inverters may be

BAD ORIGINAL

connected to the output of each of the "OR" gates and each of the "AND" gates. Thus, although Figure 1 uses non-inverting OR and AND logic it would be possible to use inverting logic (NOR and NAND). Amplifiers may also be provided at the outputs of the different gates. Amplifiers may also be connected between the outputs of the various gates and the bases of the transistors 60 to 74 (even numbers).

The apparatus described above and shown in Figure 1 is monotonic when considered on a steady-state basis in converting digital signals representing progressively values to a corresponding analog signal. This results from the fact that each progressive digital value is represented by the addition of one transistor to the number of transistors previously conductive. This may be seen from a study of the chart shown in Figure 7. Since the different transistors have substantially identical characteristics, the conversion to a state of conductivity of each additional transistor provides the addition of a substantially constant increment in the emitter current already flowing through the output line 78.

The apparatus shown in Figure 1 and described above may be incorporated on an integrated circuit chip generally indicated at 80 in Figure 2. Such incorporation may be provided by large-scale integration (LSI) or very large scale integration (VLSI) techniques. In this way, the apparatus may be self-contained. Furthermore, since all of the transistors are formed simultaneously and the chip is quite small, the transistors have substantially identical characteristics. This is particularly true since the chip has a surface area less than approximately one tenth inch (2.5 mm) square. The simultaneous formation of the transistors on such a small chip tends to assure that the current on the output line 78 represents accurately in analog form the digital information represented by the signals on the lines 12, 14, 16 and 18.

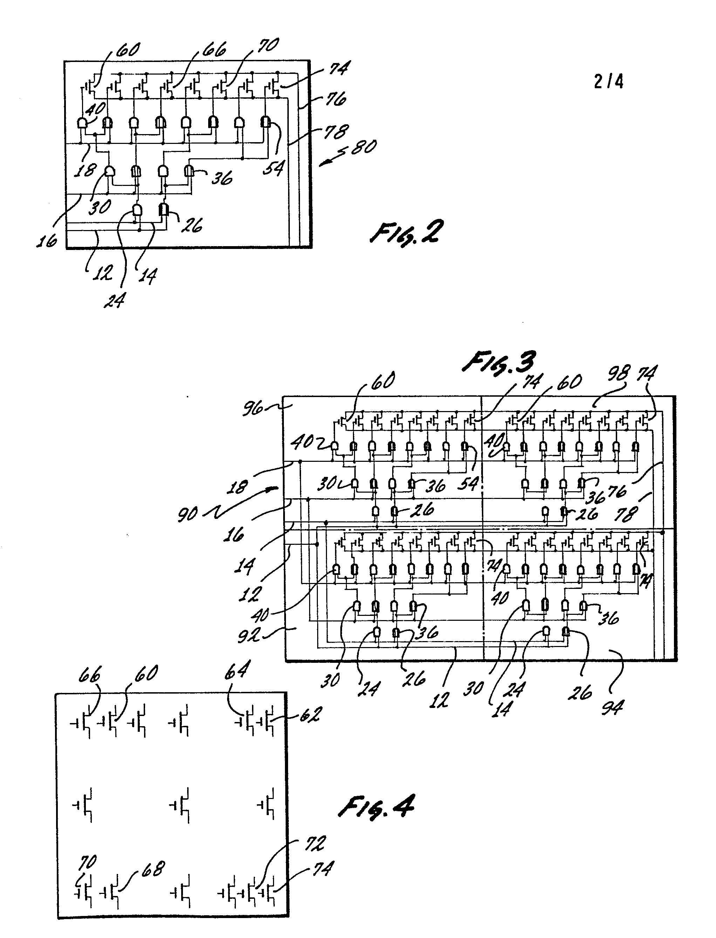

Actually, a plurality of modules may be provided on a single chip generally indicated at 90 in Figure 3. The modules are indicated schematically at 90, 92, 94, 96 and 98 in Figure 3. Each of the modules may be constructed in a manner similar to that shown in Figure 1. In this way, an increased number of digits can be provided by combining the modules 92 and 94 to provide a single output from the two modules. By providing such a combination, the modules 92 and 94 provide an output representing five (5) binary digits rather than only four (4) binary digits such as provided by either of the modules 92 or 94 when acting alone.

The modules 92 and 94 may be combined as shown in Figure 8. In this arrangement, the module shown in Figure 1 is included and is indicated at 92 in Figure 3 and by broken lines at 92 in Figure 8. The module generally indicated at 94 in Figures 3 and 8 is also included and is provided with numbers for the different gates corresponding to the numbers for the gates in the module 92 except that a prime is included after the number of each such gate. For example, the gate 24' in the module 94 corresponds to the gate 24 in the module 92. Although only the gates connected to the lines 12, 14 and 16 are shown in Figure 8 for purposes of simplification, it will be appreciated that the gates provided in the modules 92 and 94 for the line 18 may be coupled in a similar manner.

As will be seen, the gates in the module 92 are coupled to the gates in the module 94 in a repetitive manner. An "AND" gate 102 and an "OR" gate 104 are coupled to the modules 90 and 92 in an arrangement corresponding to the connection of the gates 24 and 26 in the module 92. In view of this, the line 14 now represents a value of $2^1$ and the line 12 represents a value of $2^0$. A corresponding line $12^1$ representing a value of $2^0$ is provided in the module 94. Lines 106 and 12" are connected to input terminals of the gates 102 and 104. In this way, the lines 106, 12", 14 and 16 in Figure 8 have binary values of "1", "1", "2" and "4" and the line 18 has a binary value of "8".

As will be appreciated from the above discussion, the line 12 in Figure 1 or the line 106 in Figure 8 may be considered to provide an "expansion" signal. Such a line provides for the expansion of the matrix arrangement, by the coupling of modules, to increase the number of digits involved in the conversion between analog and digital values. Furthermore, as will be appreciated, the inclusion of the expansion line in the matrix arrangement provides for the conversion of an additional digit.

In this way, additional modules can be coupled to increase the number of digits involved in the conversion. For example, the inclusion of the enabling line 12 in Figure 1 causes the matrix arrangement to provide for a conversion of digital values between "0" and "8" rather than between "0" and "7". By providing the conversion between "0" and "8", the module 94 can be directly coupled to the module 92 to provide a conversion of digital values between "0" and "16".

By further coupling the modules 96 and 98 to the modules 92 and 94, a conversion can be provided of digital values between "0" and "32".

The provision of a plurality of modules on a single chip also offers other advantages. For example, if tests indicate that the module 96 is defective, the modules 92 and 94 can still be used in combination to provide a digital significance of five (5) binary bits (including the bit represented by the signal on the line 12). This module can be sold to a customer who is interested only in an accuracy of five (5) binary bits (including the bit represented by the signal on the line 12) rather than six (6) binary bits. In this way, a defective module does not necessarily mean a destruction of the chip but indicates only that the chip may have to be downgraded in the accuracy of its conversion of digital information to analog information.

In order to increase the accuracy of the output current on the output line 78, the different transistors may be disposed in a spaced relationship such as shown in Figure 4. For example, the transistors 66 and 74 may be considered to indicate the analog value of the binary signal on the input line 16. These transistors may be accordingly disposed at spaced positions on the chip. Similarly, the transistors 62, 66, 70 and 74 may be considered to indicate in analog form the value of the signal on the line 16. The transistors 62 and 70 may accordingly be disposed in spaced relationship on the chip relative to each other and the transistors 66 and 74. The transistors 60, 64, 68 and 72 may also be disposed on the chip 80 in spaced relationship to each other and to the transistors 62, 66, 70 and 74.

BAD ORIGINAL

By disposing in a spaced relationship the transistors representing each binary digit, any deviations in the characteristics of the chip at isolated positions on the chip can be averaged in the transistors of each group so that the accuracy of the output current on the line 78 is enhanced. It will be appreciated that the arrangement shown in Figure 4 is only by way of example and that the disposition of the transistors may be provided in any suitably spaced relationship to obtain the desired averaging effect.

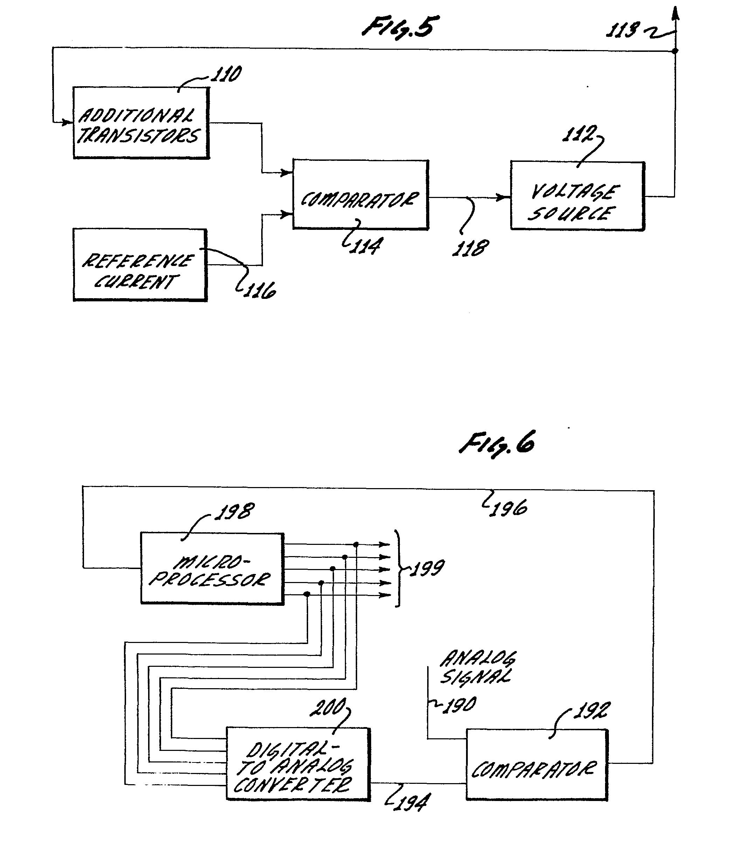

Additional transistors generally indicated at 110 in Figure 5 may also be provided on the chip 80 in Figure 2 or in the modules on the chip 90 in Figure 3. These additional transistors have characteristics substantially identical to the characteristics of the transistors in Figure 1. The additional transistors 110 operate in conjunction with the system shown in Figure 5 to regulate the current through the transistors shown in Figure 1.

In the system shown in Figure 5, a current flows through the additional transistors 110 from a voltage source 112 corresponding to the voltage source 76 in Figure 1. The current flowing through the additional transistors 110 is compared in a comparator 114 with a reference current from a source 116. The output signal 118 from the comparator 114 constitutes an error representing any difference in the comparison. The error signal is introduced to the voltage source 112 to vary the voltage from the source so that the current through the additional transistors 110 becomes equal to the reference

BAD ORIGINAL

current. The adjusted voltage from the source 112 is introduced to the collectors of the transistors of Figure 1 through a line 113 corresponding adjustments in the currents through the currents through the transistors. In this way, the current on the output line 78 is adjusted so that it provides a true analog value of the digital representation.

Any number of transistors may be used as the additional transistors 110 and may be disposed on the chip 80 in Figure 2 or in the modules 92, 94, 96 and 98 on the chip 90 in Figure 3. The additional transistors may be spaced throughout the chip 80 or throughout each of the modules on the chip 90 in a manner similar to that described for the transistors in Figure 1. As will be appreciated, a group of additional transistors 110 may be individually associated with each of the modules 92, 94, 96 and 98. In this way, the currents through the additional transistors 110 are averaged to compensate for deviations in the characteristics of the transistors in Figure 1 as a result of localized deviations in the characteristics of the material on the chip 80 in Figure 2 or the chip 90 in Figure 3.

The apparatus shown in Figures 1 through 5 and 8 and described above provides a conversion of digital signals to an analog representation. The apparatus shown in Figures 1 through 5 and 8 may also be used in a system such as shown in Figure 6 to provide a conversion of analog information to a plurality of digital signals representing the analog information.

In the embodiment shown in Figure 6, an analog signal is provided on a line 190. This analog signal is to be converted to digital form. This analog signal is compared in a comparator 192 with the analog signal on a line 194 which corresponds to the output line 78 in the converter shown in Figure 1. The results of the comparison from the comparator 192 are introduced through a line 196 to a data processor such as a microprocessor 198. The microprocessor 198 processes the information represented by the signal on the line 196 and introduces signals to the input terminals of a digital-toanalog converter 200 corresponding to the converter shown in Figure 1. The signals introduced to the digital-to-analog converter 200 cause the converter to provide an analog signal on the line 194 corresponding in characteristics to the analog signal on the line 190. When the analog signal on the line 194 corresonds in characteristics to the analog signal on the line 190, the output signals on lines 199 from the microprocessor constitute the digital signals which are introduced to the analog converter of Figure 1 to obtain a conversion into a corresponding analog signal.

The apparatus described above has certain important advantages in addition to the advantages decribed above. It provides a conversion between digital and analog values at a fast rate because the conversion results from the opening and closing of switches each controlling a simple current source. The conversion is accurate and reliable, particularly when the converter is disposed on an integrated circuit chip. This results from the fact that the chip is quite small and the chip has substantially uniform characteristics throughout its surface area. For example, the chip may have a surface area less than one tenth inch (2.5 mm) square. Furthermore, the accuracy of the conversion can be enhanced by disposing

BAD ORIGINAL

the switches in each group in a spaced relationship throughout the surface area of the chip.

The converter of this invention also has other advantages of some importance. For example, the converter is monotonic. This results from the fact that the conversion to analog form of digital signals of progressively increasing value is obtained by producing a closure of increased numbers of switches, with the resultant flow of current through the increased numbers of switches, while maintaining the conductivity of switches previously rendered conductive. Furthermore, by producing closures of switches to convert digital information to an analog form, errors resulting from differential and integral non-linearities are minimized. This is particularly true when the switches are precision transistors and when there are a considerable number of switches in the converters.

There are other important advantages to the converter of this invention. For example, the converter of this invention is quite small. This is particularly true when the converters of this invention are compared with converters which attempt to provide a comparable accuracy in the prior art. The converters of this invention are also quite inexpensive. This results in part from the production of the converter on a single chip.

The apparatus of this invention also offers the advantage of providing high output currents. This results from the fact that the amount of power delivered at the output lead, such as the lead 78 in Figure 1, can be adjusted by varying the number and size of switches in each stage. For example, the output current can be doubled by doubling the number of switches in each stage. As a result of its ability to supply a large current, the converter of this invention can be considered to provide a current amplification at the same time that it provides a conversion. This is important in such applications as the conversion of aural information such as sound. The invention accordingly has a particular utility in the recently developed techniques of digital recording and reproduction of sound.

The apparatus of this invention is easily adaptable to provide for an addition of digits to increase its accuracy. This results in part from the modular construction of the apparatus such as shown in Figure 3 and the repetitive nature of the logical matrix. The apparatus also maintains its accuracy as it ages. This is particularly true when the apparatus is disposed on a chip such as shown in Figure 2 or Figure 3. The apparatus maintains its accuracy as it ages because the chip is essentially homogeneous in construction. As a result, all of the switches on the chip age in substantially identical relationships. The disposition of the different switches in spaced relationship on the chip also facilitates an aging in which the accuracy is maintained.

The apparatus is also substantially free of the effects of temperature for substantially the same reasons as discussed above with respect to aging. This is particularly true when the current on the output terminal is regulated as shown in Figure 5 and as discussed above. Such avoidance in the chip of the effects of temperature variations also results from the fact that the distribution of the switches in each group throughout the surface area of the chip prevents the temperature of the chip from becoming excessive at any localized areas.

Although this application has been disclosed and illustrated with reference to particular applications, the principles involved are susceptible of numerous other applications which will be apparent to persons skilled in the art. The invention is, therefore, to be limited only as indicated by the scope of the appended claims.

CLAIMS

1. A digital-to-analog converter comprising switches controlled by digital signals having different weights, characterised in that there are more switches (62-74) than digital signals (12, 16, 18) and by a logic network (22) responsive to the digital signals to render conductive a number of the switches corresponding to the combined weights of such of the digital signals as have a particular value.

2. A digital-to-analog converter according to claim 1, characterised in that the switches (60 - 74) are connected in parallel to pass a current proportional to the number of switches which are conductive.

3. A digital-to-analog converter according to claim 1 or 2, characterised in that the logic network (22) comprises groups of gates (32 - 36; 42 - 54), each group comprising gates forming AND and OR functions of a corresponding digital signal and output signals from the group corresponding to the next lower significance digital signal, and the switches (62 -74) being controlled by the gates respectively (42 -54) of the most significant group.

4. A digital-to-analog converter according to claim 3, wherein the digital signals are binary signals, characterised in that each group (e.g. 32, 34, 36) consists of $2^n$ OR gates and $2^n - 1$ AND gates where the weight of the corresponding digital signal is $2^n$.

5. A digital-to-analog converter according to any of claims 1 to 4, characterised by a supplementary lowest significance input digital signal line 14, and AND logic (24, 30, 40) responsive to all digital signals (12, 14, 16, 18) to control a further switch (60).

6. A digital-to-analog converter according to any of claims 1 to 5, characterised in that the switches are transistors.

7. A digital-to-analog converter according to claim 6, characterised in that the logic network (22) has outputs connected to gates or bases of the transistors (62 -74), sources or emitters of the transistors are connected to an output line (78) and drains or collectors of the transistors are connected to a voltage source (76 or 112).

8. A digital-to-analog converter according to claim 7, characterised in that every change of the combination of digital signals (12, 16, 18) having the said particular value representing an increase of the digital value to be converted causes exclusively the addition of a further conductive one of the switches (62 -74).

9. A digital-to-analog converter according to any of claims 1 to 8, characterised in that the switches (62 -74) and the logical network (22) are formed on an integrated circuit chip (80).

10. A digital-to-analog converter according to claim 9, characterised in that the switches which are conductive for each digital signal are distributed throughout the chip.

11. A digital-to-analog converter according to claim 9 or 10, characterised in that the chip (90) carries a plurality of modules (92, 94, 96, 98), each constituting a converter as defined in claim 1, the modules being usable together to extend the number of digits handled by the converter.

12. A digital-to-analog converter according to claim 11, characterised by further gates (102, 104) responsive to two signal lines (12, 106) to provide least-significant digit inputs to two modules (92, 94).

13. A digital-to-analog converter according to claims 1 to 12, characterised by a plurality of additional switches (110) acting as reference switches, means (114) for comparing the current passed by the reference switches with a reference current (116) and for adjusting (118) the voltage of a source (112) connected to the first said and additional switches.

BAD ORIGINAL

14. An analog-to-digital converter comprising a digital-to-analog converter (200) according to any of claims 1 to 13, characterised by means (192) for comparing an input analog signal (190) with the signal (194) from the digital-to-analog converter (200) and means (198) responsive to a resultant difference signal (196) to adjust the digital signals which are provided on output lines (199) and to the inputs of the digital-to-analog converter (200).

60
62
64
66
68
70
72
74
78
40
42
44
46
48
50
52
54
18
30
32
34
36
22
76
VOLTAGE SOURCE
16
24
26
14
12

Fig. 1

60
66
70
74
76
40
78
80
54
18
36
30
16
26
12
14
24

FIG. 2

60
74
60
98
74
96
40
40
18
30
36
54
36
76
90
16
26
26
78
14
12
74
40
74
40
36
92
36
30
24
26
12
30
24
14
26
94
66
60
64
62
72
70
68
74

FIG. 3

FIG. 4

Fig.5
113
110
ADDITIONAL TRANSISTORS
112
COMPARATOR
VOLTAGE SOURCE
114
118
REFERENCE CURRENT
116

Fig.6
196
198
MICRO-PROCESSOR
199
ANALOG SIGNAL
190
200
192
DIGITAL-TO ANALOG CONVERTER
COMPARATOR
194

| LINE 12 | 14 | 16 | 18 | SWITCH CLOSED 74 | 72 | 70 | 68 | 66 | 64 | 62 | 60 | CURRENT OUT |
|---|---|---|---|---|---|---|---|---|---|---|---|---|
| 0 | 0 | 0 | 0 | | | | | | | | | 0 |
| 1 | 0 | 0 | 0 | X | | | | | | | | 1 |
| 0 | 1 | 0 | 0 | X | | | | | | | | 1 |
| 1 | 1 | 0 | 0 | X | | | | X | | | | 2 |
| 0 | 0 | 1 | 0 | X | | | | X | | | | 2 |
| 1 | 0 | 1 | 0 | X | | X | | X | | | | 3 |
| 0 | 1 | 1 | 0 | X | | X | | X | | | | 3 |
| 1 | 1 | 1 | 0 | X | | X | | X | | X | | 4 |
| 0 | 0 | 0 | 1 | X | | X | | X | | X | | 4 |
| 1 | 0 | 0 | 1 | X | X | X | | X | | X | | 5 |
| 0 | 1 | 0 | 1 | X | X | X | | X | | X | | 5 |
| 1 | 1 | 0 | 1 | X | X | X | | X | X | X | | 6 |
| 0 | 0 | 1 | 1 | X | X | X | | X | X | X | | 6 |
| 1 | 0 | 1 | 1 | X | X | X | X | X | X | X | | 7 |
| 0 | 1 | 1 | 1 | X | X | X | X | X | X | X | | 7 |
| 1 | 1 | 1 | 1 | X | X | X | X | X | X | X | X | 8 |

FIG. 7

FIG. 8

30
32
34
36
30'
32'
34'
36'
16
24
26
24'
26'
14
12
12'
92
94
102
104
12"
106